# EUROPEAN PATENT APPLICATION

(11) **EP 1 705 700 A1**
(43) Date of publication of application: **27.09.2006**
(21) Application number: 06005960.7
(22) Date of filing: 23.03.2006
(51) Int. Cl.: H01L 21/316, H01L 21/314, C30B 5/00

(54) **Lead zirconate titanate niobate film, lead zirconate titanate niobate laminate and method of manufacturing the same, surface acoustic wave device, frequency filter, oscillator, electronic circuit, and electronic instrument**

(30) Priority: 24.03.2005 JP 2005086188
(71) Applicant: SEIKO EPSON CORPORATION, Shinjuku-ku, Tokyo 163-0811 (JP)
(72) Inventor: Kijima, Takeshi, Suwa-shi Nagano-ken 392-8502 (JP); Higuchi, Takamitsu, Suwa-shi Nagano-ken 392-8502 (JP)
(74) Representative: Hoffmann, Eckart

(57) **Abstract**

A lead zirconate titanate niobate laminate includes a sapphire substrate and a lead zirconate titanate niobate film formed on the sapphire substrate.

## Description

### BACKGROUND OF THE INVENTION

The present invention relates to a lead zirconate titanate niobate film, a lead zirconate titanate niobate laminate and a method of manufacturing the same, a surface acoustic wave device, a frequency filter, an oscillator, an electronic circuit, and an electronic instrument.

A demand for a surface acoustic wave device has rapidly increased along with a remarkable development in the communication field represented by a mobile communication device such as a portable telephone. The development of the surface acoustic wave device is trending toward a smaller size, higher efficiency, and higher frequency. A larger electromechanical coupling factor (k²), more stable temperature characteristics, and a higher surface acoustic wave propagation speed are necessary to achieve a smaller size, higher efficiency, and higher frequency. When using the surface acoustic wave device as a high frequency filter, a larger electromechanical coupling factor is desired to obtain a pass band with a small loss and a wide bandwidth. In order to increase the resonance frequency, a material which allows a higher speed of sound is required due to limitations to the design rule of the pitch of inter-digital transducers. The temperature coefficient of frequency (TCF) must be small in order to stabilize the properties at the operating temperature.

A surface acoustic wave device having a structure in which inter-digital transducers are formed on a piezoelectric single crystal has been mainly used. As typical piezoelectric single crystals, a rock crystal, lithium niobate (LiNbO₃), lithium tantalate (LiTaO₃), and the like can be given. For example, LiNbO₃ having a large electromechanical coupling factor is used for an RF filter for which an increase in band and a decrease in loss in the pass band are required. A rock crystal having a small temperature coefficient of frequency is used for an IF filter for which stable temperature characteristics are required in a narrow band. LiTaO₃ having an intermediate electromechanical coupling factor and a temperature coefficient of frequency between those of LiNbO₃ and a rock crystal plays an intermediate role between LiNbO₃ and a rock crystal. However, the electromechanical coupling factor of LiNbO₃, which has the largest electromechanical coupling factor, is only about 20%.

In the surface acoustic wave device using a piezoelectric single crystal substrate, properties such as the electromechanical coupling factor, the temperature coefficient, and the speed of sound are values specific to the material and are determined by the cutting angle and the propagation direction.

The speed of sound, the electromechanical coupling factor, and the temperature characteristics are expected to be increased by depositing a piezoelectric thin film on a substrate and controlling the thickness of the piezoelectric thin film. For example, Jpn. J. Appl. Phys. Vol. 32 (1993) 2337 discloses a zinc oxide (ZnO) thin film formed on a sapphire substrate, and Jpn. J. Appl. Phys. vol. 32 (1993) L745 discloses an LiNbO₃ thin film formed on a sapphire substrate.

It is desirable that the piezoelectric thin film be oriented in a direction optimum for ensuring the electromechanical coupling factor and the temperature characteristics. In order to reduce a loss caused by propagation of surface acoustic waves, it is desirable that the piezoelectric thin film be a flat and dense epitaxial film.

A thin film having a large electromechanical coupling factor is expected to be obtained by using lead zirconate titanate having a large piezoelectric constant. However, it is difficult to form a lead zirconate titanate thin film while maintaining high insulating properties and reliability. Moreover, lead zirconate titanate cannot be formed on a large insulator substrate as an epitaxial film.

### SUMMARY

A first aspect of the invention relates to a lead zirconate titanate niobate film epitaxially grown in a tetragonal (110) or (101) orientation or a rhombohedral (110) orientation.

A second aspect of the invention relates to a lead zirconate titanate niobate laminate comprising a sapphire substrate and a lead zirconate titanate niobate film formed on the sapphire substrate.

A third aspect of the invention relates to a method of manufacturing a lead zirconate titanate niobate laminate, the method comprising:
providing a sapphire substrate;
providing a precursor composition including a precursor for forming a lead zirconate titanate niobate film, the precursor including at least niobium, titanium, and zirconium and having a partial ester bond; and
applying the precursor composition to the sapphire substrate and heating the precursor composition to form a lead zirconate titanate niobate film.

A fourth aspect of the invention relates to a surface acoustic wave device having the above lead zirconate titanate niobate film.

A fifth aspect of the invention relates to a surface acoustic wave device having the above lead zirconate titanate niobate laminate.

A sixth aspect of the invention relates to a frequency filter having one of the above surface acoustic wave devices.

A seventh aspect of the invention relates to an oscillator having one of the above surface acoustic wave devices.

An eighth aspect of the invention relates to an electronic circuit having at least one of the above frequency filter and the above oscillator.

A ninth aspect of the invention relates to an electronic instrument having the above electronic circuit.

### BRIEF DESCRIPTION OF THE SEVERAL VIEWS OF THE DRAWING

FIG 1 is a cross-sectional view schematically showing a lead zirconate titanate niobate laminate according to a first embodiment.
FIG 2 shows lead-containing carboxylic acids used in the first embodiment.
FIG 3A shows a polycarboxylic acid or a polycarboxylic acid ester used in the first embodiment, FIG 3B shows a polycarboxylic acid or a polycarboxylic acid ester used in the first embodiment, FIG 3C shows a polycarboxylic acid or a polycarboxylic acid ester used in the first embodiment, and FIG 3D shows a polycarboxylic acid or a polycarboxylic acid ester used in the first embodiment.
FIG 4 shows a precursor formation reaction in a precursor composition used in the first embodiment.
FIG 5 shows a precursor formation reaction in a precursor composition used in the first embodiment.
FIG 6 is an X-ray diffraction diagram of lead zirconate titanate niobate according to an example.
FIG 7A and FIG 7B show an X-ray diffraction pole figure of an R-plane sapphire substrate and lead zirconate titanate niobate according to the example.
FIG 8 is a cross-sectional view showing a surface acoustic wave device according to a second embodiment.
FIG 9 is an oblique view showing a frequency filter according to a third embodiment.
FIG. 10 is an oblique view showing an oscillator according to a fourth embodiment.
FIG. 11 is a schematic view showing an example in which the oscillator according to the fourth embodiment is applied to a VCSO.
FIG 12 is a schematic view showing an example in which the oscillator according to the fourth embodiment is applied to a VCSO.
FIG. 13 is a block diagram showing a basic configuration of a PLL circuit.
FIG 14 is a block diagram showing a configuration of an electronic circuit according to a fifth embodiment.
FIG 15 shows a communication system using reader/writer according to the fifth embodiment.
FIG 16 is a schematic block diagram of the communication system shown in FIG 15.

### DETAILED DESCRIPTION OF THE EMBODIMENT

The invention may provide a lead zirconate titanate niobate film, a lead zirconate titanate niobate laminate including the lead zirconate titanate niobate film, and a method of manufacturing the lead zirconate titanate niobate laminate.

The invention may also provide a surface acoustic wave device having a large electromechanical coupling factor.

The invention may also provide a frequency filter, an oscillator, an electronic circuit, and an electronic instrument including the surface acoustic wave device.

One embodiment of the invention provides a lead zirconate titanate niobate film epitaxially grown in a tetragonal (110) or (101) orientation or a rhombohedral (110) orientation.

The lead zirconate titanate niobate film according to this embodiment may have twofold inplane symmetry.

The lead zirconate titanate niobate film according to this embodiment may include niobium in an amount of 5 to 30 mol% of a total amount of niobium, titanium, and zirconium.

The lead zirconate titanate niobate film according to this embodiment may include silicon or silicon and germanium in an amount of 0.5 mol% or more.

One embodiment of the invention provides a lead zirconate titanate niobate laminate comprising a sapphire substrate and a lead zirconate titanate niobate film formed on the sapphire substrate.

With the lead zirconate titanate niobate laminate according to this embodiment, the sapphire substrate may be an R-plane (1-102) sapphire substrate.

With the lead zirconate titanate niobate laminate according to this embodiment, the lead zirconate titanate niobate film may be epitaxially grown in a tetragonal (110) or (101) orientation or a rhombohedral (110) orientation.

With the lead zirconate titanate niobate laminate according to this embodiment, the lead zirconate titanate niobate film may have twofold inplane symmetry.

With the lead zirconate titanate niobate laminate according to this embodiment, a [001] axis in the tetragonal (110) orientation, a [010] axis in the tetragonal (101) orientation, or a [001] axis in the (110) orientation of the lead zirconate titanate niobate film may be parallel to a [11-20] direction of the R-plane of the sapphire substrate.

With the lead zirconate titanate niobate laminate according to this embodiment, the lead zirconate titanate niobate film may include niobium in an amount of 5 to 30 mol% of the total amount of niobium, titanium, and zirconium.

With the lead zirconate titanate niobate laminate according to this embodiment, the lead zirconate titanate niobate film may include silicon or silicon and germanium in an amount of 0.5 mol% or more.

One embodiment of the invention provides a method of manufacturing a lead zirconate titanate niobate laminate, the method comprising:
providing a sapphire substrate;
providing a precursor composition including a precursor for forming a lead zirconate titanate niobate film, the precursor including at least niobium, titanium, and zirconium and having a partial ester bond; and
applying the precursor composition to the sapphire substrate and heating the precursor composition to form a lead zirconate titanate niobate film.

With the method of manufacturing a lead zirconate titanate niobate laminate according to this embodiment, the precursor further may include lead.

With the method of manufacturing a lead zirconate titanate niobate laminate according to this embodiment, the precursor may be dissolved or dispersed in an organic solvent.

With the method of manufacturing a lead zirconate titanate niobate laminate according to this embodiment, the organic solvent may be an alcohol.

With the method of manufacturing a lead zirconate titanate niobate laminate according to this embodiment, the precursor composition may be obtained by mixing a sol-gel raw material including a hydrolysis-condensation product of a metal alkoxide of at least niobium, titanium, and zirconium, a polycarboxylic acid or a polycarboxylic acid ester, and an organic solvent, and may include the precursor having an ester bond obtained by esterification of the polycarboxylic acid or a polycarboxylic acid derived from the polycarboxylic acid ester and the metal alkoxide.

With the method of manufacturing a lead zirconate titanate niobate laminate according to this embodiment, the polycarboxylic acid or the polycarboxylic acid ester may be a dicarboxylic acid or a dicarboxylic acid ester.

With the method of manufacturing a lead zirconate titanate niobate laminate according to this embodiment, the dicarboxylic acid ester may be at least one ester selected from a succinic acid ester, a maleic acid ester, and a malonic acid ester.

With the method of manufacturing a lead zirconate titanate niobate laminate according to this embodiment, the precursor composition may be obtained by mixing a sol-gel raw material using a metal carboxylate together with the sol-gel raw material, the polycarboxylic acid or the polycarboxylic acid ester, and the organic solvent.

With the method of manufacturing a lead zirconate titanate niobate laminate according to this embodiment, the metal carboxylate may be a lead carboxylate.

With the method of manufacturing a lead zirconate titanate niobate laminate according to this embodiment, the precursor composition may be obtained by mixing an organometallic compound together with the sol-gel raw material, the polycarboxylic acid or the polycarboxylic acid ester, and the organic solvent.

With the method of manufacturing a lead zirconate titanate niobate laminate according to this embodiment, the precursor composition may be obtained by mixing a sol-gel raw material including silicon or silicon and germanium together with the sol-gel raw material; the polycarboxylic acid or the polycarboxylic acid ester, and the organic solvent.

With the method of manufacturing a lead zirconate titanate niobate laminate according to this embodiment, a mixed solution prepared by mixing at least a PbZrO₃ sol-gel solution, a PbTiO₃ sol-gel solution, and a PbNbO₃ sol-gel solution may be used as the sol-gel raw material.

With the method of manufacturing the lead zirconate titanate niobate laminate according to this embodiment, the sol-gel raw material may be prepared by further mixing a PbSiO₃ sol-gel solution.

One embodiment of the invention provides a surface acoustic wave device having the above lead zirconate titanate niobate film.

One embodiment of the invention provides a surface acoustic wave device having the above lead zirconate titanate niobate laminate.

One embodiment of the invention provides a frequency filter having any one of the above surface acoustic wave devices.

One embodiment of the invention provides an oscillator having any one of the above surface acoustic wave devices.

An electronic circuit according to one embodiment of the invention has one of the above the frequency filter and the above oscillator.

An electronic instrument according to one embodiment of the invention has the above electronic circuit.

The embodiments of the invention are described below with reference to the drawings.

### 1. First Embodiment

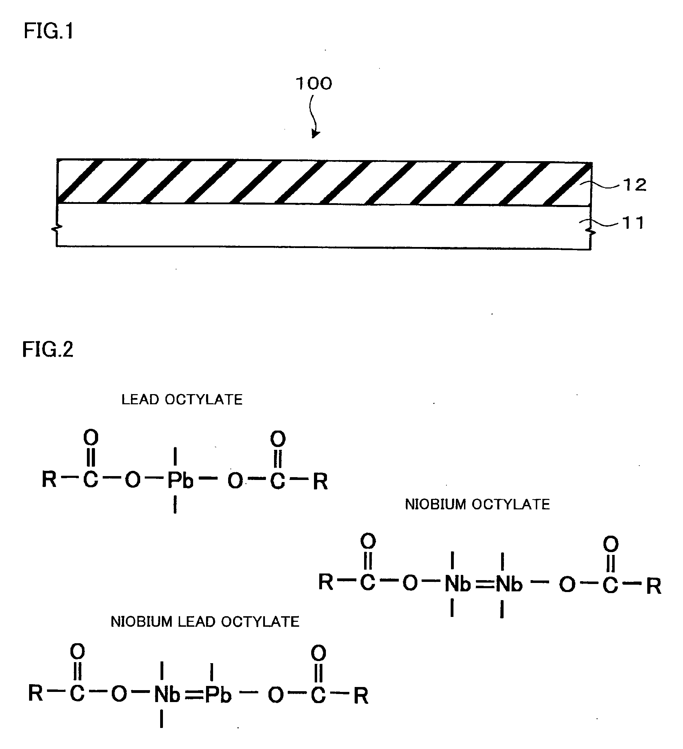

### 1.1. FIG 1 a cross-sectional view schematically showing a lead zirconate titanate niobate laminate 100 according to a first embodiment.

As shown in FIG 1, the lead zirconate titanate niobate laminate 100 according to the first embodiment may include a substrate 11 and a lead zirconate titanate niobate film 12 according to the first embodiment formed on the substrate 11.

As the substrate 11, an R-plane sapphire substrate may be used. It is preferable to use the R-plane sapphire substrate since the lead zirconate titanate niobate film 12 can be epitaxially grown, a substrate having a large area is available at low cost, and the R-plane sapphire substrate can be repeatedly used due to resistance to an etchant.

The lead zirconate titanate niobate (Pb(Zn,Ti,Nb)O₃) (hereinafter may be called "PZTN") film 12 according to the first embodiment has a crystal structure in which the lead zirconate titanate niobate film 12 is epitaxially grown in a tetragonal (110) or (101) orientation or a rhombohedral (110) orientation, as is clear from examples described later. The lead zirconate titanate niobate film 12 has twofold inplane symmetry. Specifically, the lead zirconate titanate niobate film 12 according to the first embodiment has a single crystal structure which has not been obtained. Since the lead zirconate titanate niobate film 12 has twofold symmetry, the lead zirconate titanate niobate film 12 has a single domain structure which does not have different domains by a polarization treatment or the like or spontaneously.

In the lead zirconate titanate niobate film 12 according to the first embodiment, the [001] axis in the tetragonal (110) orientation, the [010] axis in the tetragonal (101) orientation, or the [001] axis in the rhombohedral (110) orientation is parallel to the [11-20] direction of the R-plane of the sapphire substrate.

As described above, since the lead zirconate titanate niobate film 12 according to the first embodiment is an epitaxially grown single crystal and has a single domain structure, a domain boundary does not exist. Therefore, the lead zirconate titanate niobate film 12 has a small energy loss at the crystal grain boundaries, a small propagation loss of surface acoustic waves, and a large electromechanical coupling factor.

The lead zirconate titanate niobate film according to the first embodiment may include niobium in an amount of preferably 5 mol% or more, and still more preferably 10 mol% or more and 30 mol% or less of the total amount of niobium, titanium, and zirconium. The lead zirconate titanate niobate film according to the first embodiment may include silicon or silicon and germanium in an amount of preferably 0.5 mol% or more, and still more preferably 0.5 to 5 mol%.

The features of the lead zirconate titanate niobate film according to the first embodiment due to inclusion of niobium are described below.

Niobium has a size almost equal to the size of titanium (i.e. niobium and titanium have ionic radii close to each other and have an identical atomic radius) and has a weight twice the weight of titanium. Therefore, niobium is not easily released from the lattice even if a collision occurs between atoms due to lattice vibration. Niobium is stable at a valence of +5. Therefore, even if lead is released from the lattice, the valence of lead can be compensated for by Nb⁵⁺. Moreover, even if lead is released during crystallization, it is easier for niobium having a small size to enter the lattice than oxygen having a large size to be released.

Since niobium with a valence of +4 also exists, niobium can replace Ti⁴⁺. Moreover, since niobium has very strong covalent bonding properties, niobium is not easily released (H. Miyazawa, E. Natori, S. Miyashita; Jpn. J. Appl. Phys. 39 (2000) 5679).

According to the lead zirconate titanate niobate (PZTN) film according to the first embodiment, since the lead zirconate titanate niobate film includes a specific amount of niobium, the lead zirconate titanate niobate film exhibits excellent composition controllability due to the absence of an adverse effect caused by lead deficiency. As a result, PZTN exhibits an excellent electromechanical coupling factor, piezoelectric properties, insulating properties, and the like in comparison with known Pb(Zr,Ti)O₃ (PZT).

Niobium has been doped into PZT mainly in the Zr-rich rhombohedral region. However, the amount of doping is as small as about 0.2 to 0.025 mol% (J. Am. Ceram. Soc, 84 (2001) 902; Phys. Rev. Let, 83 (1999) 1347). This is because the crystallization temperature is increased by adding a large amount of niobium (e.g. 800°C or more when adding niobium in an amount of 10 mol%).

It is preferable to add silicon to the PZTN film according to the first embodiment in an amount of 0.5 to 5 mol%, for example. This reduces the crystallization energy of PZTN. Specifically, the first embodiment may reduce the crystallization temperature of PZTN can be decreased by adding silicon in addition to niobium. Silicon and germanium may be used instead of using only silicon.

As described above, according to the lead zirconate titanate niobate film 12 according to the first embodiment and the lead zirconate titanate niobate laminate 100 including the lead zirconate titanate niobate film 12, since the lead zirconate titanate niobate film 12 is a single crystal having a specific orientation, has a single domain structure, and includes niobium in a specific amount, the lead zirconate titanate niobate film 12 and the lead zirconate titanate niobate laminate 100 including the lead zirconate titanate niobate film 12 have extremely excellent properties such as a large electromechanical coupling factor, excellent piezoelectric properties, and excellent insulating properties. Therefore, the lead zirconate titanate niobate film 12 and the lead zirconate titanate niobate laminate 100 including the lead zirconate titanate niobate film 12 may be suitably applied to a surface acoustic wave device, a frequency filter, an oscillator, or the like.

The thickness of the lead zirconate titanate niobate film 12 is not particularly limited, and may be appropriately selected depending on the device to which the lead zirconate titanate niobate film 12 is applied. The thickness of the lead zirconate titanate niobate film 12 may be 100 nm to 10 µm, for example.

### 1.2. A method of manufacturing the lead zirconate titanate niobate laminate 100 according to the first embodiment is described below.

(1) As shown in FIG 1, the substrate 11 made of an R-plane sapphire substrate (hereinafter may be called "R-plane sapphire substrate") is provided. The R-plane sapphire substrate 11 has been cleaned by washing in advance. The cleaning by washing may be performed by immersing the R-plane sapphire substrate 11 in an organic solvent and washing the R-plane sapphire substrate 11 using an ultrasonic washing machine. The organic solvent is not particularly limited. For example, a mixed solution of ethyl alcohol and acetone may be used.
(2) A precursor composition is applied to the R-plane sapphire substrate 11 and heated to form the lead zirconate titanate niobate film 12. The coating method for the precursor composition is not particularly limited. A known coating method such as a spin coating method or a dipping method may be used. The heat treatment includes at least a heat treatment for crystallizing the precursor composition. The heat treatment is not particularly limited. A known method such as a rapid thermal annealing (RTA) method may be used.

The precursor composition includes a precursor for forming lead zirconate titanate niobate. The precursor includes at least niobium, titanium, and zirconium, and has a partial ester bond. The precursor is dissolved or dispersed in an organic solvent. As the organic solvent, an alcohol may be used. The alcohol is not particularly limited. As examples of the alcohol, monohydric alcohols such as butanol, methanol, ethanol, and propanol, and polyhydric alcohols can be given. Specific examples of the alcohol are given below.

### Monohydric alcohol:

Propanol (propyl alcohol): 1-propanol (boiling point: 97.4°C) and 2-propanol (boiling point: 82.7°C)
Butanol (butyl alcohol): 1-butanol (boiling point: 117°C), 2-butanol (boiling point: 100°C), 2-methyl-1-propanol (boiling point: 108°C), and 2-methyl-2-propanol (melting point: 25.4°C, boiling point: 83°C)
Pentanol (amyl alcohol): 1-pentanol (boiling point: 137°C), 3-methyl-1-butanol (boiling point: 131°C), 2-methyl-1-butanol (boiling point: 128°C), 2,2-dimethyl-1-propanol (boiling point: 113°C), 2-pentanol (boiling point: 119°C), 3-methyl-2-butanol (boiling point: 112.5°C), 3-pentanol (boiling point: 117°C), and 2-methyl-2-butanol (boiling point: 102°C)

### Polyhydric alcohol:

Ethylene glycol (melting point: -11.5°C, boiling point: 197.5°C) and glycerol (melting point: 17°C, boiling point: 290°C)

In the precursor composition used in the first embodiment, since the precursor includes an ester bond formed by esterification of a polycarboxylic acid and a metal alkoxide so that a reversible reaction can occur, the polymerized precursor can be decomposed into the metal alkoxide, as described later in detail. Therefore, the metal alkoxide can be recycled as the precursor raw material.

The precursor composition used in the first embodiment also has the following advantages. A commercially available PZT sol-gel solution generally contains lead acetate as the lead raw material. However, since lead acetate bonds to an alkoxide of Ti or Zr to only a small extent, it is difficult for lead to enter the precursor network. According to the first embodiment, since lead can easily enter the precursor network as described later in detail, the precursor composition includes the network (precursor) containing lead. Therefore, the precursor composition used in the first embodiment exhibits excellent composition controllability in comparison with a known sol-gel raw material, so that lead can be prevented from being released from PZTN.

This feature is described below taking succinic acid which is a dicarboxylic acid as an example. A first carboxyl group, which is one of two carboxyl groups of succinic acid initially functioning as an acid, has a pH of 4.0, which is lower than that of acetic acid (pH=4.56) (i.e. stronger than acetic acid). Therefore, lead acetate bonds to succinic acid. Specifically, a reaction indicated by "salt of weak acid + strong acid ? salt of strong acid + weak acid" occurs. Moreover, since the remaining second carboxyl group of succinic acid bonds to another MOD molecule or alkoxide, lead can easily enter the precursor network.

The precursor composition used in the first embodiment is obtained as follows.

The precursor composition is obtained by mixing a sol-gel raw material containing a hydrolysis-condensation product of a metal alkoxide, a polycarboxylic acid or a polycarboxylic acid ester, and an organic solvent. The sol-gel raw material includes at least niobium, titanium, and zirconium. The resulting precursor composition includes a precursor having an ester bond resulting from esterification of the polycarboxylic acid or a polycarboxylic acid derived from the polycarboxylic acid ester and the metal alkoxide.

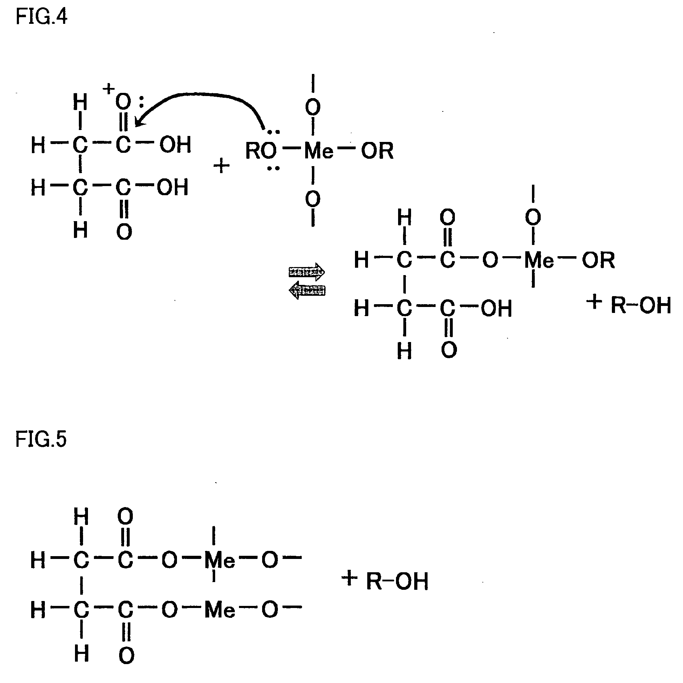

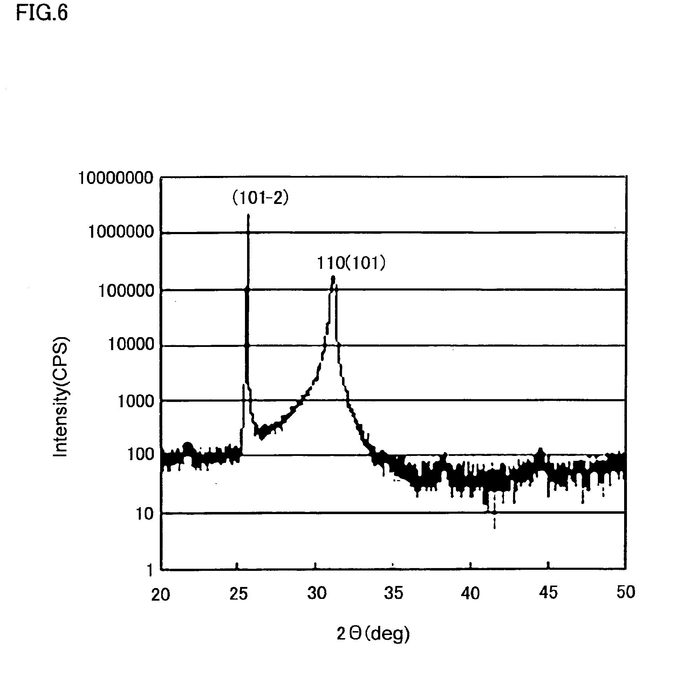

FIGS. 4 and 5 schematically show the precursor formation reaction in the manufacturing method according to the first embodiment.

The precursor formation reaction is roughly divided into a first-stage alkoxyl group substitution reaction as shown in FIG 4, and a second-stage polymer network formation reaction by esterification as shown in FIG 5. FIGS. 4 and 5 illustrate an example of using dimethyl succinate as the polycarboxylic acid ester and n-butanol as the organic solvent. Although dimethyl succinate is nonpolar, dimethyl succinate dissociates in an alcohol to produce a dicarboxylic acid.

In the first-stage reaction, dimethyl succinate and the metal alkoxide of the sol-gel raw material undergo esterification and are bonded through an ester bond, as shown in FIG 4. Specifically, dimethyl succinate dissociates in n-butanol so that one of the carbonyl groups (first carbonyl group) is protonated. A substitution reaction occurs between the first carbonyl group and the alkoxyl group of the metal alkoxide to produce a reaction product, in which the first carboxyl group is esterified, together with an alcohol. The "ester bond" used herein means a bond (-COO-) formed by a carbonyl group and an oxygen atom.

In the second-stage reaction, a substitution reaction occurs between the carboxyl group (second carboxyl group) remaining unreacted in the first-stage reaction and the alkoxyl group of the metal alkoxide to produce a reaction product, in which the second carboxyl group is esterified, and an alcohol.

A polymer network in which the hydrolysis-condensation products of the metal alkoxide included in the sol-gel raw material are bonded through ester bonds is obtained by the above two-stage reaction. Therefore, the polymer network includes a moderate amount of ester bond in the network. Since dimethyl succinate dissociates in two stages and the first carboxyl group has an acid dissociation constant greater than the acid dissociation constant of the second carboxyl group, the first-stage reaction has a rate of reaction higher than the rate of reaction of the second-stage reaction. Therefore, the second-stage reaction proceeds more slowly than the first-stage reaction.

In the first embodiment, any of the following methods may be used to promote the above-described esterification reaction.
(1) The concentration or reactivity of the reaction product may be increased. In more detail, the reactivity is increased by increasing the degree of dissociation of the polycarboxylic acid or the polycarboxylic acid ester by increasing the temperature of the reaction system. It is preferable that the temperature of the reaction system be higher than room temperature and lower than the boiling point of the organic solvent, although the temperature of the reaction system varies depending on the boiling point of the organic solvent. The temperature of the reaction system may be 100°C or less, and preferably 50 to 100°C, for example.
(2) A reaction by-product may be removed. In more detail, esterification is promoted by removing water and an alcohol produced during esterification.
(3) The molecular motion of the reaction product may be physically accelerated. In more detail, the reactivity of the reaction product is increased by applying energy rays such as ultraviolet rays.

The organic solvent used in the method of manufacturing the precursor composition may be the above-mentioned alcohol. The sol-gel raw material and the polycarboxylic acid or the polycarboxylic acid ester can be efficiently dissolved by using an alcohol as the solvent.

The amount of polycarboxylic acid or polycarboxylic acid ester used is adjusted depending on the compositional ratio of the sol-gel raw material and PZTN. The ratio of the total molar ion concentration of the PZT sol-gel raw material, PbNb sol-gel raw material, and PbSi sol-gel raw material, to which the polycarboxylic acid is bonded, to the molar ion concentration of the polycarboxylic acid is set at preferably "1 ≤ (molar ion concentration of polycarboxylic acid) / (total molar ion concentration of raw material solution)", and still more preferably 1:1. The polycarboxylic acid may be added in an amount of 0.35 mol, for example.

Specifically, it is preferable that the amount of polycarboxylic acid or polycarboxylic acid ester added be equal to or greater than the total number of moles of the raw material solution. All the raw materials bond when the ratio of the molar ionic concentration is 1:1. However, since an ester stably exists in an acidic solution, it is preferable to add the polycarboxylic acid in excess to the total number of moles of the raw material solution in order to allow an ester to stably exist. The number of moles of the polycarboxylic acid or the polycarboxylic acid ester used herein refers to the molar ionic concentration obtained by dividing the number of moles by the number of carboxyl groups. Specifically, when using a dicarboxylic acid or a dicarboxylic acid ester, one molecule of the dicarboxylic acid or the dicarboxylic acid ester can bond to two raw material molecules. Therefore, the ratio is 1:1 when the amount of dicarboxylic acid or dicarboxylic acid ester is 0.5 mol for one mol of the raw material solution.

The polycarboxylic acid ester does not initially function as an acid. The polycarboxylic acid ester produces a polycarboxylic acid when caused to dissociate in an alcohol. In this case, it is preferable that the alcohol be added so that "1 ≤ (number of moles of alcohol / number of moles of polycarboxylic acid ester)". This is because the polycarboxylic acid ester more sufficiently and stably dissociates as the number of moles of alcohol is greater. The number of moles of alcohol and the number of moles of polycarboxylic acid ester used herein refer to the molar ion concentration obtained by dividing the number of moles of alcohol by the number of hydroxyl groups and the molar ion concentration obtained by dividing the number of moles of polycarboxylic acid ester by the number of carboxyl groups, respectively.

In the method of manufacturing the precursor composition, the polycarboxylic acid or the polycarboxylic acid ester may be a carboxylic acid or a carboxylic acid ester having two or more carboxyl groups. As examples of the polycarboxylic acid, the following compounds can be given.

As examples of a tricarboxylic acid, trans-aconitic acid, trimesic acid, and the like can be given. As examples of a tetracarboxylic acid, pyromellitic acid, 1,2,3,4-cyclopentanetetracarboxylic acid, and the like can be given. As examples of the polycarboxylic acid ester which dissociates in an alcohol to function as a polycarboxylic acid, dicarboxylic acid esters such as dimethyl succinate, diethyl succinate, dibutyl oxalate, dimethyl malonate, dimethyl adipate, dimethyl maleate, and diethyl fumarate, tricarboxylic acid esters such as tributyl citrate and triethyl 1,1,2-ethanetricarboxylate, tetracarboxylic acid esters such as tetraethyl 1,1,2,2-ethanetetracarboxylate and trimethyl 1,2,4-benzenetricarboxylate, and the like can be given.

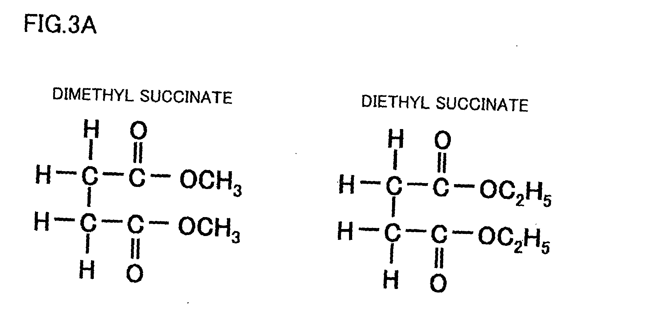

These polycarboxylic acid esters dissociate in the presence of an alcohol to function as polycarboxylic acids. FIGS. 3A to 3D show examples of the above-mentioned polycarboxylic acids and polycarboxylic acid esters. A feature of the precursor composition used in the first embodiment is that the network is grown by esterification using the polycarboxylic acid. The ester network is not grown when using a monocarboxylic acid or a monocarboxylic acid ester, such as acetic acid or methyl acetate.

In the method of manufacturing the precursor composition, the dicarboxylic acid ester is preferably at least one compound selected from a succinic acid ester, a maleic acid ester, and a malonic acid ester. As specific examples of these esters, dimethyl succinate, dimethyl maleate, and dimethyl malonate can be given.

The polycarboxylic acid ester preferably has a molecular weight of 150 or less. If the molecular weight of the polycarboxylic acid ester is too high, the film may be damaged when the ester volatilizes during heat treatment, so that a dense film may not be obtained. The polycarboxylic acid ester is preferably liquid at room temperature. If the polycarboxylic acid ester is solid at room temperature, gelation may occur.

The method of manufacturing the precursor composition may include mixing a sol-gel raw material including a metal carboxylate when mixing the sol-gel raw material, the polycarboxylic acid or the polycarboxylic acid ester, and the organic solvent. As examples of such a metal carboxylate, lead carboxylate such as lead acetate can be given. Further examples include lead octylate, niobium octylate, and niobium lead octylate as shown in FIG 2.

In the method of manufacturing the precursor composition, an organometallic compound (MOD raw material) may be used when mixing the sol-gel raw material, the polycarboxylic acid or the polycarboxylic acid ester, and the organic solvent. According to the method of manufacturing the precursor composition, not only the alkoxide raw materials, but also the MOD raw material and the alkoxide raw material can be bonded through ester bonds.

As the organometallic compound, niobium octylate may be used, for example. As shown in the FIG 2, niobium octylate has a structure in which two Nb atoms form a covalent bond and an octyl group exists in the remaining site. In this case, since a network other than the two Nb atoms does not exist, niobium octylate is regarded as the MOD raw material.

A network is formed between the carboxylic acid and the MOD raw material mainly through an alcohol exchange reaction. When using niobium octylate, a reaction occurs between the carboxylic acid and the octyl group (alcohol exchange reaction), so that esterification (R-COO-Nb) proceeds. As described above, according to the first embodiment, the molecules of the MOD raw material can be bonded to the precursor network through condensation between the MOD raw material and the alkoxide by esterifying the MOD raw material.

In the method of manufacturing the precursor composition, a solution prepared by mixing at least a PbZrO₃ sol-gel solution, a PbTiO₃ sol-gel solution, and a PbNbO₃ sol-gel solution may be used as the sol-gel solution. For example, the PbNbO₃ sol-gel solution may include niobium lead octylate (see FIG 2) formed by mixing lead octylate with niobium octylate and obtained by the alcohol exchange reaction between lead octylate and niobium octylate.

In the method of manufacturing the precursor composition, a sol-gel raw material including silicon or silicon and germanium may be used as the sol-gel raw material including the hydrolysis-condensation product of the metal alkoxide. The crystallization temperature can be decreased as described above by adding such a sol-gel raw material. As such a sol-gel solution, a PbSiO₃ sol-gel solution or a combination of a PbSiO₃ sol-gel solution and a PbGeO₃ sol-gel solution may be used. The deposition temperature can be reduced by using the sol-gel raw material including silicon or germanium, whereby a PZTN can be crystallized at a temperature as low as about 450°C.

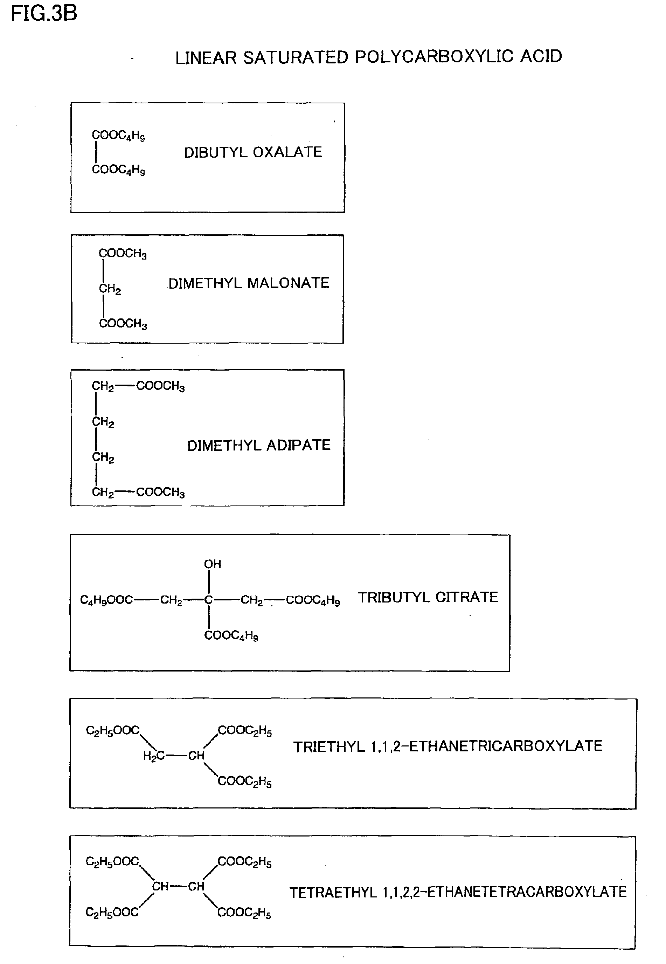

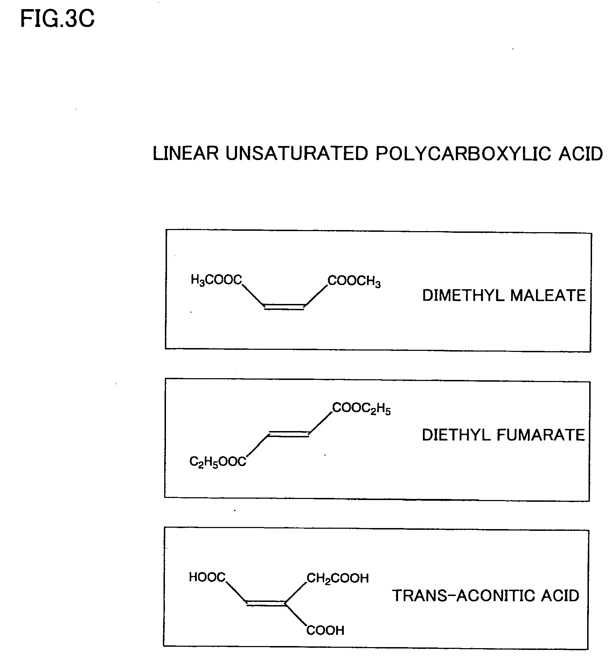

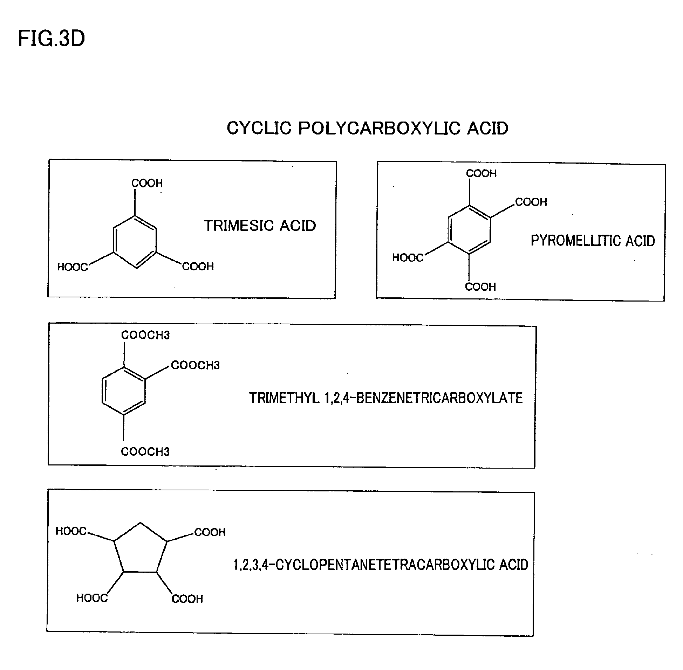

Since the precursor of the precursor composition includes a moderate amount of ester bond between the molecular networks, a reversible reaction can occur. Therefore, the polymerized precursor (polymer network) may be decomposed into the metal alkoxide condensate by causing the reaction in the left direction shown in FIG 3 to occur.

The lead zirconate titanate niobate laminate 100 shown in FIG. 1 can be formed by these steps.

In the first embodiment, a polishing treatment for planarizing the surface of the lead zirconate titanate niobate film 12 may be arbitrarily performed. As the grinding treatment, buff polishing, chemical mechanical polishing (CMP), or the like may be used.

The manufacturing method according to the first embodiment has the following features.

According to the first embodiment, since the lead zirconate titanate niobate film 12 is obtained by applying the precursor composition to the R-plane sapphire substrate 11 and heating the precursor composition, the lead zirconate titanate niobate film 12 can be obtained by a process easier than a vapor phase method.

According to the manufacturing method according to the first embodiment, the lead zirconate titanate niobate film 12 which is a single crystal and has a uniform domain can be formed on the R-plane sapphire substrate 11. Such a lead zirconate titanate niobate film is extremely useful due to its excellent electromechanical coupling factor, insulating properties, and the like, and may be applied to various applications such as a surface acoustic wave device.

The mechanism by which the lead zirconate titanate niobate film 12 is obtained by the manufacturing method according to the first embodiment is not clarified. However, it is considered that the effects of the precursor composition described below cannot be ignored. In the manufacturing method according to the first embodiment, a polymer network, in which the hydrolysis-condensation products (molecular networks) of the metal alkoxide of the sol-gel raw material are bonded through ester bonds, is obtained by the polycarboxylic acid in the organic solvent of the precursor composition. Therefore, the polymer network includes a moderate amount of ester bond between the molecular networks derived from the hydrolysis-condensation products. The esterification reaction can be easily carried out by controlling the temperature or the like.

Since the precursor composition used in the first embodiment includes a moderate amount of ester bond between the molecular networks, a reversible reaction can occur. Therefore, the polymerized precursor (polymer network) can be decomposed into the metal alkoxide (or molecular network of the condensation product) in the composition remaining after deposition of the PZTN film. Since the metal alkoxide (or molecular network of the condensation product) can be recycled as the precursor raw material, a toxic substance such as lead can be recycled. Therefore, it is advantageous from the viewpoint of the environment.

The precursor composition used in the first embodiment allows lead to easily enter the precursor network since it includes the molecular network (precursor) containing lead, thereby exhibiting high composition controlability.

### 1.3. Example

In this example, the lead zirconate titanate niobate laminate 100 (see FIG 1) was formed by the following method. In this example, a single crystal lead zirconate titanate niobate thin film could be obtained.

The R-plane sapphire substrate 11 made of an R surface sapphire single crystal substrate was immersed in an organic solvent, and cleaned by washing using an ultrasonic washing machine. As the organic solvent, a 1:1 mixed solution of ethyl alcohol and acetone was used.

In this example, a precursor composition was obtained as described below. The precursor composition was obtained by mixing first to third raw material solutions, each containing at least one of Pb, Zr, Ti, and Nb, dimethyl succinate (polycarboxylic acid ester), and n-butanol (organic solvent). The mixed solution was prepared by dissolving the sol-gel raw material and dimethyl succinate in n-butanol at a ratio of 1:1 (molar ionic concentration).

As the first raw material solution, a solution in which, a polycondensation product for forming a PbZrO₃ perovskite crystal formed by Pb and Zr among the constituent metal elements of PZTN was dissolved in n-butanol in an anhydrous state, was used.

As the second raw material solution, a solution, in which a polycondensation product for forming a PbTiO₃ perovskite crystal formed by Pb and Ti among the constituent metal elements of PZTN was dissolved in n-butanol in an anhydrous state, was used.

As the third raw material solution, a solution, in which a polycondensation product for forming a PbNbO₃ perovskite crystal formed by Pb and Nb among the constituent metal elements of PZTN was dissolved in n-butanol in an anhydrous state, was used.

When forming a PbZr_{0.2}Ti_{0.6}Nb_{0.2}O₃ (PZTN) film using the first, second, and third raw material solutions, the first, second, and third raw material solutions are mixed at a ratio of "(first raw material solution):(second raw material solution):(third raw material solution) = 2:6:2". In order to reduce the crystallization temperature of the PZTN film, a solution, in which a polycondensation product for forming a PbSiO₃ crystal was dissolved in n-butanol in an anhydrous state, was added as a fourth raw material solution in an amount of 3 mol % . Specifically, the crystallization temperature of PZTN can be reduced to 700°C or less by using a mixed solution of the first, second, third, and fourth raw material solutions as the sol-gel raw material.

A sample was obtained by the following method.

The first to fourth raw material solutions and dimethyl succinate were dissolved in n-butanol to prepare a solution. The solution was heated at 80°C for 60 minutes to prepare a solution (precursor composition). The solution was applied to the R-plane sapphire substrate 11 by spin coating, and dried at 150 to 180°C (150°C) on a hot plate to remove the alcohol. Then, a cleaning heat treatment was performed at 300 to 350°C (300°C) on a hot plate. Then, the coating step, the drying treatment step, and the cleaning heat treatment step were performed an optional number of times to obtain a coating film having a desired thickness. The coating film was then subjected to crystallization annealing (sintering) to obtain the PZTN film 12 having a thickness of 150 nm. The crystallization sintering was performed in an oxygen atmosphere at 650 to 700°C (700°C) by rapid thermal annealing (RTA).

A sample of the lead zirconate titanate niobate laminate 100 (see FIG 1) was obtained by the above-described steps. The sample was subjected to X-ray analysis to obtain the following results.

FIG 6 shows the X-ray diffraction pattern (2?-? scan) of the sample of the lead zirconate titanate niobate film 12. All the peaks shown in the X-ray diffraction pattern of FIG. 6 are attributed to sapphire and lead zirconate titanate niobate. A peak attributed to other compounds was not observed. Therefore, the peak of the PZTN (110) orientation (or (101) orientation) was observed when expressing the lead zirconate titanate niobate obtained in this example by tetragonal plane indices.

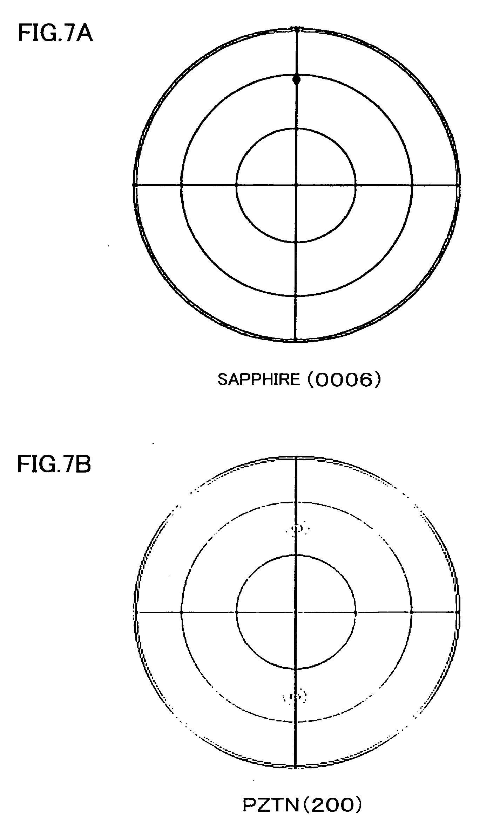

FIGS. 7A and 7B show X-ray diffraction pole figures of sapphire (0006) (2?=41.7°) and PZTN (200) (2?=44.8°). As is clear from these results, it was confirmed that PZTN had twofold symmetry, and had an inter-layer epitaxial orientation relationship of "PZTN (110)/sapphire (1-102)" and an inplane epitaxial orientation relationship of "PZTN [001]//sapphire [11-20]". Specifically, it was confirmed that the lead zirconate titanate niobate film 12 according to this example was a single crystal and had a single domain structure in which the crystal growth direction is made uniform by either a polarization treatment or the like or spontaneously.

### 2. Second Embodiment

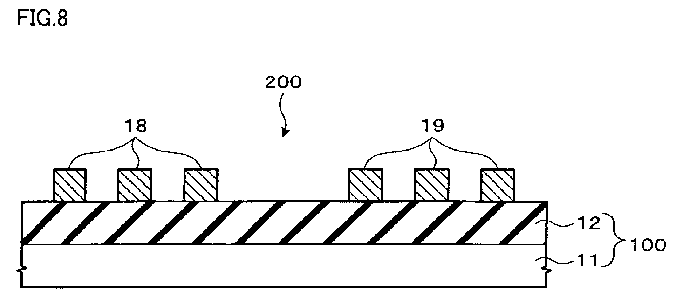

An example of a surface acoustic wave device according to a second embodiment of the invention is described below with reference to the drawings. FIG 8 is a cross-sectional view schematically showing a surface acoustic wave device 200 according to the second embodiment. In FIG 8, members substantially the same as the members of the lead zirconate titanate niobate laminate 100 shown in FIG 1 are indicated by the same symbols. Detailed description of these members is omitted.

The surface acoustic wave device 200 includes the substrate 11, the lead zirconate titanate niobate film 12 formed on the substrate 11, and inter-digital transducers (hereinafter called "IDT electrodes") 18 and 19 formed on the lead zirconate titanate niobate film 12. The IDT electrodes 18 and 19 have a specific pattern.

The surface acoustic wave device 200 according to the second embodiment includes a lead zirconate titanate niobate laminate according to the invention, such as the lead zirconate titanate niobate laminate 100 shown in FIG 1. Therefore, the lead zirconate titanate niobate film 12 forming the surface acoustic wave device 200 has the features described in the first embodiment. Specifically, the lead zirconate titanate niobate film 12 has a specific orientation and has a single crystal structure with twofold symmetry formed by epitaxial growth.

The surface acoustic wave device 200 according to the second embodiment is formed as follows using the lead zirconate titanate niobate laminate according to the invention.

A metal layer is formed on the lead zirconate titanate niobate film 12 of the lead zirconate titanate niobate laminate 100 shown in FIG. 1 by a vacuum deposition method, for example. Aluminum may be used as the material for the metal layer, for example. The IDT electrodes 18 and 19 are formed on the lead zirconate titanate niobate film 12 by patterning the metal film using a known lithography technology and etching technology.

The surface acoustic wave device 200 according to the second embodiment includes the lead zirconate titanate niobate film according to the invention. Therefore, according to the second embodiment, a surface acoustic wave device having a large electromechanical coupling factor can be realized.

An experimental example conducted for the surface acoustic wave device 200 according to the second embodiment is described below.

The surface acoustic wave device 200 of the example was formed by using the lead zirconate titanate niobate laminate 100 of the example of the first embodiment. As the IDT electrode, an aluminium layer having a thickness of 100 nm was used. The line and space pattern of the IDT electrode was 1.25 µm.

The resulting surface acoustic wave device 200 was subjected to measurement of the surface acoustic wave delay time Vₒₚₑₙ between the IDT electrodes 18 and 19. The speed of sound determined from the result was 4000 m/s. The electromechanical coupling factor calculated from the difference from the surface acoustic wave delay time Vₛₕₒᵣₜ when covering the space between the IDT electrodes 18 and 19 with a metal thin film was 5%.

### 3. Third Embodiment

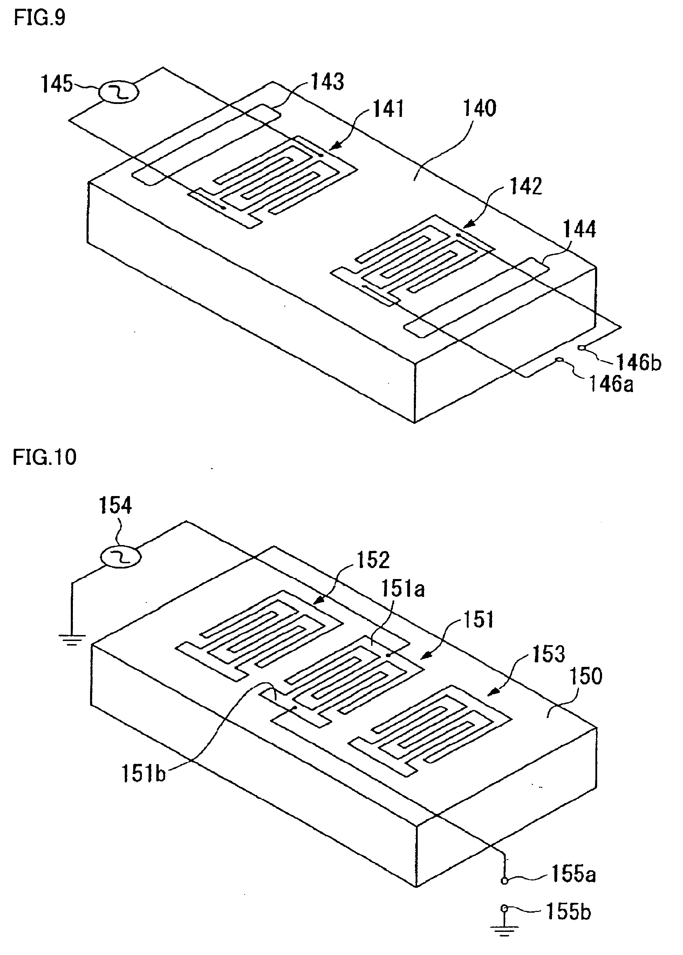

An example of a frequency filter according to a third embodiment of the invention is described below with reference to the drawings. FIG 9 schematically shows the frequency filter according to the third embodiment.

As shown in FIG. 9, the frequency filter includes a base 140. As the base 140, a lead zirconate titanate niobate laminate according to the invention, such as the lead zirconate titanate niobate laminate 100 shown in FIG 1, may be used.

IDT electrodes 141 and 142 are formed on the upper side of the base 140. Sound absorbing sections 143 and 144 are formed on the upper side of the base 140 so that the IDT electrodes 141 and 142 are positioned between the sound absorbing sections 143 and 144. The sound absorbing sections 143 and 144 absorb surface acoustic waves propagated on the surface of the base 140. A high-frequency signal source 145 is connected with the IDT electrode 141, and a signal line is connected with the IDT electrode 142.

The operation of the frequency filter is described below.

In the above-described configuration, when a high-frequency signal is output from the high-frequency signal source 145, the high-frequency signal is applied to the IDT electrode 141 so that surface acoustic waves occur on the upper side of the base 140. The surface acoustic waves propagated from the IDT electrode 141 toward the sound absorbing section 143 are absorbed by the sound absorbing section 143. However, the surface acoustic waves propagated toward the sound absorbing section 142 and having a specific frequency determined according to the pitch of the IDT electrode 142 or the like or having a frequency in a specific band are converted into electric signals, and removed at terminals 146a and 146b through the signal lines. Most of the frequency components other than a specific frequency or a frequency in a specific band are absorbed by the sound absorbing section 144 through the IDT electrode 142. Therefore, it is possible to obtain (filter) only surface acoustic waves having a specific frequency or a frequency in a specific band from electric signals supplied to the IDT electrode 141 of the frequency filter according to the third embodiment.

### 4. Fourth Embodiment

An example of an oscillator according to a fourth embodiment of the invention is described below with reference to the drawings. FIG 10 schematically shows the oscillator according to the fourth embodiment.

As shown in FIG 10, the oscillator includes a base 150. As the base 150, a lead zirconate titanate niobate laminate according to the invention, such as the lead zirconate titanate niobate laminate 100 shown in FIG 1, may be used in the same manner as the above-describe frequency filter.

An IDT electrode 151 is formed on the upper side of the base 150, and IDT electrodes 152 and 153 are formed so that the IDT electrode 151 is positioned between the IDT electrodes 152 and 153. A high-frequency signal source 154 is connected with a comb-shaped electrode 151a forming the IDT electrode 151, and a signal line is connected with the other comb-shaped electrode 151b. The IDT electrode 151 corresponds to an electrode for applying an electric signal, and the IDT electrodes 152 and 153 correspond to electrodes for causing a specific frequency component or a frequency component in a specific band of surface elastic waves generated by the IDT electrode 151 to resonate.

The operation of the oscillator is described below.

In the above-described configuration, when a high-frequency signal is output from the high-frequency signal source 154, the high-frequency signal is applied to the comb-shaped electrode 151a of the IDT electrode 151, so that surface acoustic waves propagated toward the IDT electrode 152 and surface acoustic waves propagated toward the IDT electrode 153 are generated on the upper side of the base 150. The surface acoustic waves having a specific frequency component are reflected by the IDT electrodes 152 and 153 so that stationary waves occur between the IDT electrodes 152 and 153. The surface acoustic waves having a specific frequency component are repeatedly reflected by the IDT electrodes 152 and 153 so that a specific frequency component or a frequency. component in a specific band resonates to increase the amplitude. A part of the surface acoustic waves having a specific frequency component or a frequency component in a specific band is removed through the comb-shaped electrode 151b of the IDT electrode 151, so that electric signals having a frequency corresponding to the resonant frequency of the IDT electrodes 152 and 153 (or frequency having a certain band) can be removed at terminals 155a and 155b.

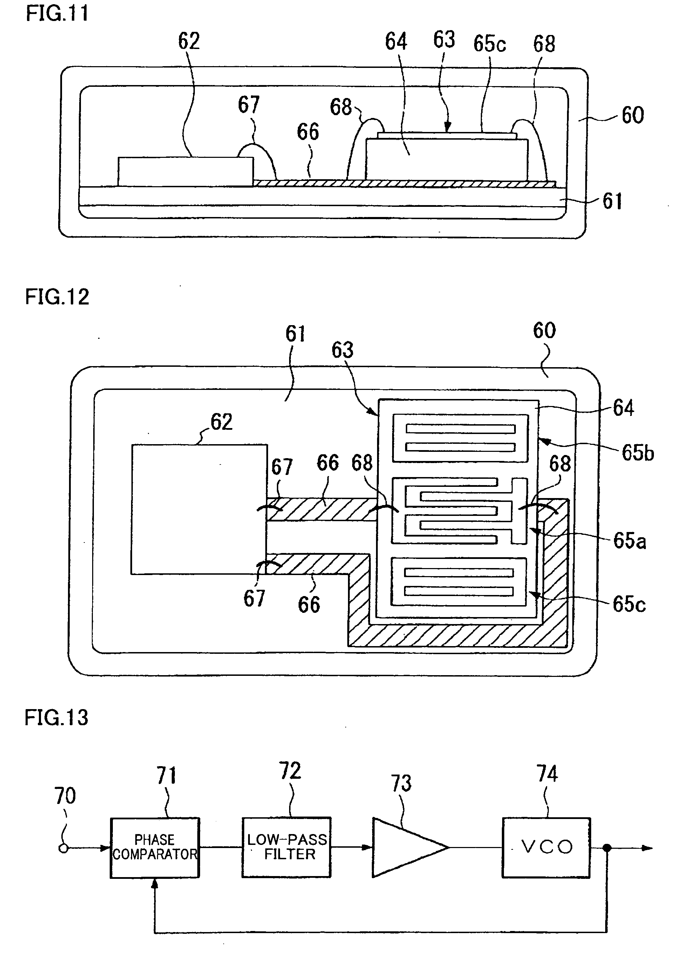

FIGS. 11 and 12 schematically show an example in which the above-described oscillator is applied to a voltage controlled SAW oscillator (VCSO). FIG 11 is a side perspective view, and FIG 12 is a top perspective view.

The VCSO is provided in a housing 60 made of a metal (aluminum or stainless steel). An integrated circuit (IC) 62 and an oscillator 63 are provided on a substrate 61. In this case, the IC 62 is an oscillating circuit which controls the frequency applied to the oscillator 63 corresponding to the voltage value input from an external circuit (not shown).

In the oscillator 63, IDT electrodes 65a to 65c are formed on a base 64. The configuration of the oscillator 63 is almost the same as the configuration of the oscillator shown in FIG. 10. As the base 64, a lead zirconate titanate niobate laminate according to the invention, such as the lead zirconate titanate niobate laminate 100 shown in FIG 1, may be used in the same manner as in the oscillator shown in FIG 10.

An interconnect 66 for electrically connecting the IC 62 with the oscillator 63 is patterned on the substrate 61. The IC 62 and the interconnect 66 are connected through a wire 67 such as a gold wire, and the oscillator 63 and the interconnect 66 are connected through a wire 68 such as a gold wire. This allows the IC 62 and the oscillator 63 to be electrically connected through the interconnect 66.

The VCSO shown in FIGS. 11 and 12 is used as a voltage controlled oscillator (VCO) of a PLL circuit shown in FIG 13, for example. FIG 13 is a block diagram showing the basic configuration of the PLL circuit. The PLL circuit includes a phase comparator 71, a low-pass filter 72, an amplifier 73, and a VCO 74. The phase comparator 71 compares the phase (or frequency) of a signal input through an input terminal 70 with the phase (or frequency) of a signal output from the VCO 74, and generates an error voltage signal of which the value is set corresponding to the difference determined by comparison. The low-pass filter 72 allows only a low-frequency component at a position of the error voltage signal output from the phase comparator 71 to pass therethrough. The amplifier 73 amplifies the signal output from the low-pass filter 72. The VCO 74 is an oscillating circuit of which the oscillation frequency continuously changes within a certain range corresponding to the input voltage value.

The PLL circuit having such a configuration operates so that the difference between the phase (or frequency) of the signal input through the input terminal 70 and the phase (or frequency) of the signal output from the VCO 74 is decreased, and synchronizes the frequency of the signal output from the VCO 74 with the frequency of the signal input through the input terminal 70. When the frequency of the signal output from the VCO 74 has been synchronized with the frequency of the signal input through the input terminal 70, the PLL circuit then outputs a signal which coincides with the signal input through the input terminal 70 excluding a constant phase difference and follows a change in the input signal.

As described above, the frequency filter and the oscillator according to the fourth embodiment include the surface acoustic wave device according to the invention having a large electromechanical coupling factor. Therefore, according to the fourth embodiment, the size of the frequency filter and the oscillator can be reduced.

### 5. Fifth Embodiment

5.1. A first example of an electronic circuit and an electronic instrument according to a fifth embodiment of the invention is described below with reference to the drawings.

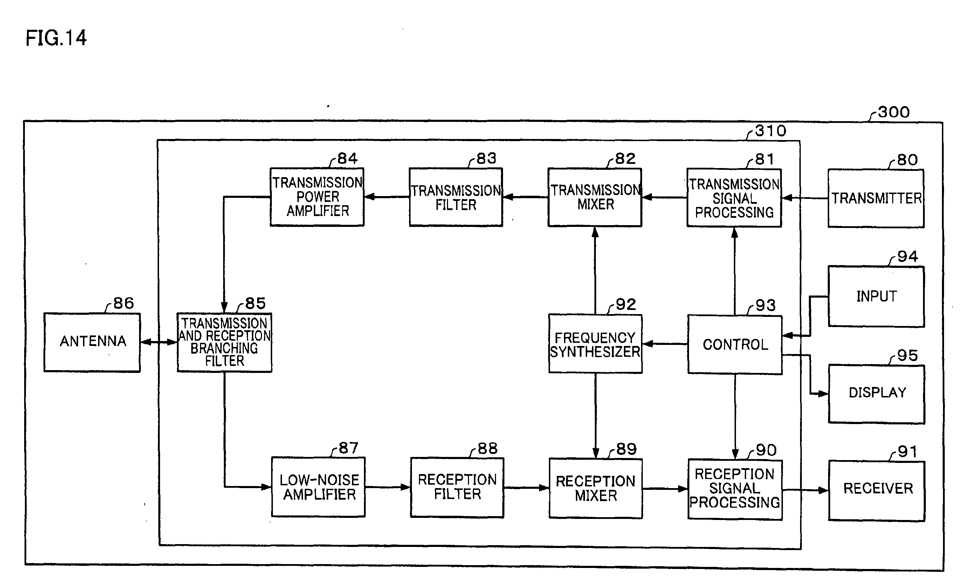

FIG 14 is a block diagram showing the electrical configuration of the electronic instrument to the fifth embodiment. The electronic instrument is a portable telephone or the like.

An electronic instrument 300 includes an electronic circuit 310, a transmitter 80, a receiver 91, an input section 94, a display section 95, and an antenna section 86. The electronic circuit 310 includes a transmission signal processing circuit 81, a transmission mixer 82, a transmission filter 83, a transmission power amplifier 84, a transmission and reception branching filter 85, a low-noise amplifier 87, a reception filter 88, a reception mixer 89, a reception signal processing circuit 90, a frequency synthesizer 92, and a control circuit 93.

In the electronic circuit 310, the frequency filter shown in FIG 9 may be used as the transmission filter 83 and the reception filter 88. The frequency to be filtered (frequency allowed to pass) is individually set for the transmission filter 83 and the reception filter 88 corresponding to the necessary frequency of the signal output from the transmission mixer 82 and the frequency necessary for the reception mixer 89. As the VCO 74 of the PLL circuit (see FIG. 13) provided in the frequency synthesizer 92, the oscillator shown in FIG. 10 or the VCSO shown in FIGS. 11 and 12 may be used.

The transmitter 80 is realized by using a microphone which converts a sound wave signal into an electric signal, for example. The transmission signal processing circuit 81 is a circuit which performs D/A conversion processing, modulation processing, or the like for an electric signal output from the transmitter 80. The transmission mixer 82 mixes the signal output from the transmission signal processing circuit 81 by using the signal output from the frequency synthesizer 92. The transmission filter 83 allows only a signal at a frequency for which an intermediate frequency (hereinafter abbreviated as "IF") is necessary to pass therethrough, and removes a signal at an unnecessary frequency. The signal output from the transmission filter 83 is converted into an RF signal by a conversion circuit (not shown). The transmission power amplifier 84 amplifies electric power of the RF signal output from the transmission filter 83, and outputs it to the transmission and reception branching filter 85.

The transmission and reception branching filter 85 outputs the RF signal output from the transmission power amplifier 84 to the antenna section 86, and transmits the RF signal from the antenna section 86 as electric waves. The transmission and reception branching filter 85 branches a signal received by the antenna section 86, and outputs the resulting signal to the low-noise amplifier 87. The low-noise amplifier 87 amplifies the signal received from the transmission and reception branching filter 85. The signal output from the low-noise amplifier 87 is converted into IF by a conversion circuit (not shown).

The reception filter 88 allows only a signal at a frequency for which IF converted by the conversion circuit (not shown) is necessary to pass therethrough, and removes a signal at an necessary frequency. The reception mixer 89 mixes the signal output from the reception filter 88 by using the signal output from the frequency synthesizer 92. The reception signal processing circuit 90 is a circuit which performs A/D conversion processing, demodulation processing, or the like for the signal output from the reception mixer 89. The receiver 91 is realized by using a small speaker which converts electric signals into sound waves, for example.

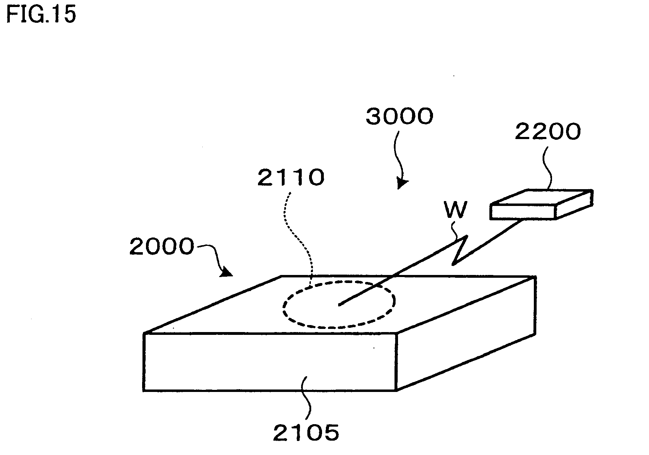

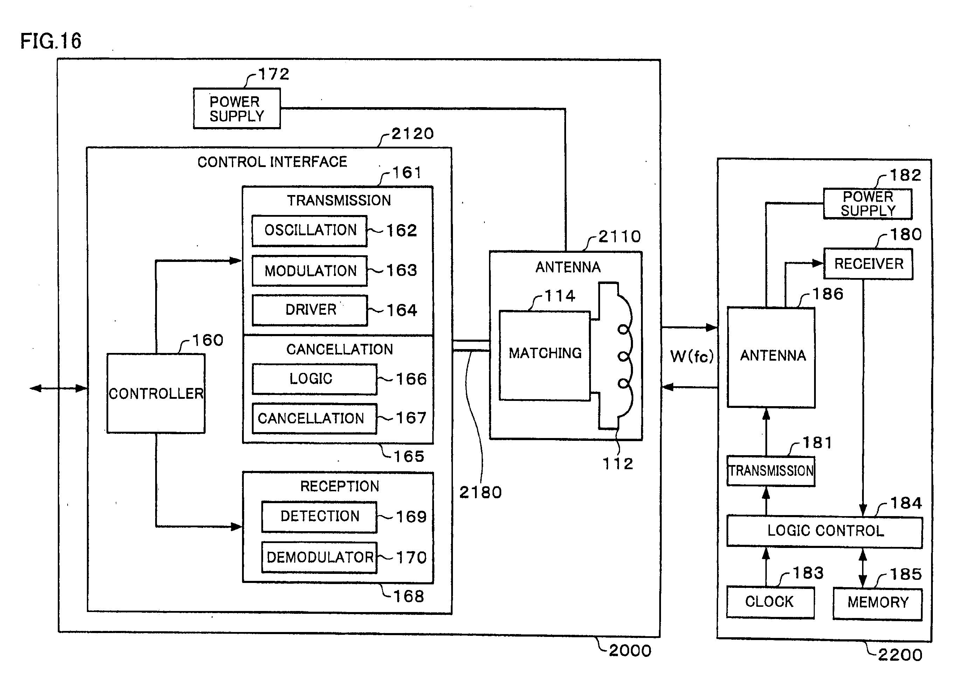

The frequency synthesizer 92 is a circuit which generates a signal supplied to the transmission mixer 82 and a signal supplied to the reception mixer 89. The frequency synthesizer 92 includes a PLL circuit, and generates a signal by dividing the frequency of a signal output from the PLL circuit. The control circuit 93 controls the transmission signal processing circuit 81, the reception signal processing circuit 90, the frequency synthesizer 92, the input section 94, and the display section 95. The display section 95 displays the state of the instrument for the user of the portable telephone, for example. The input section 94 allows the user of the portable telephone to input instructions, for example.
5.2. A second example of the electronic circuit and the electronic instrument according to the fifth embodiment of the invention is described below with reference to the drawings. In the fifth embodiment, a reader/writer 2000 and a communication system 3000 using the reader/writer 2000 are described as an example of the electronic instrument. FIG 15 shows the communication system 3000 using the reader/writer 2000 according to the fifth embodiment, and FIG 16 is a schematic block diagram of the communication system 3000 shown in FIG 15.

As shown in FIG 15, the communication system 3000 includes the reader/writer 2000 and a noncontact information medium 2200. The reader/writer 2000 transmits or receives radio waves W (hereinafter may be called "carrier") having a carrier frequency f_{c} to or from the noncontact information medium 2200, and communicates with the noncontact information medium 2200 using wireless communication. The radio wave W may use the carrier frequency f_{c} at an arbitrary frequency band. As shown in FIGS. 15 and 16, the reader/writer 2000 includes a main body 2105, an antenna section 2110 positioned on the upper side of the main body 2105, a control interface section 2120 provided in the main body 2105, and a power supply circuit 172. The antenna section 2110 and the control interface section 2120 are electrically connected through a cable 2180. The reader/writer 2000 is connected with an external host device (e.g. processing device) through the control interface section 2120 (not shown).

The antenna section 2110 has the function of transmitting and receiving information to and from the noncontact information medium 2200. As shown in FIG. 15, the antenna section 2110 has a specific communication area (area indicated by the dotted line). The antenna section 2110 includes a loop antenna 112 and a matching circuit 114.

The control interface section 2120 includes a transmission section 161, a damped oscillation cancellation section 140 (hereinafter called "cancellation section"), a reception section 168, and a controller 160.

The transmission section 161 modulates data transmitted from an external device (not shown), and transmits the modulated data to the loop antenna 112. The transmission section 161 includes an oscillation circuit 162, a modulation circuit 163, and a driver circuit 164. The oscillation circuit 162 is a circuit for generating a carrier at a specific frequency. The oscillation circuit 162 is generally formed using a quartz resonator or the like. The communication frequency and the detection sensitivity can be increased by using the oscillator according to the invention. The modulation circuit 163 is a circuit which modulates the carrier according to information provided. The driver circuit 164 receives the modulated carrier and amplifies electric power to drive the antenna section 2110.

The cancellation section 165 has a function of reducing the damped oscillation caused by the loop antenna 112 of the antenna section 2110 along with turning the carrier ON/OFF. The cancellation section 165 includes a logic circuit 166 and a cancellation circuit 167.

The reception section 168 includes a detection section 169 and a demodulator circuit 170. The reception section 168 restores a signal transmitted from the noncontact information medium 2200. The detection section 169 detects a change in current which flows through the loop antenna 112, for example. The demodulator circuit 170 is a circuit which demodulates the change detected by the detection section 169.

The controller 160 acquires information from the demodulated signal and transfers the information to the external device. The power supply circuit 172 receives power from the outside, arbitrarily performs voltage conversion, and supplies necessary power to each circuit. A built-in cell may be used as the power supply.

The noncontact information medium 2200 communicates with the reader/writer 2000 using electromagnetic waves (radio waves). As examples of the noncontact information medium 2200, a noncontact IC tag, a noncontact IC card, and the like can be given.

The operation of the communication system 3000 using the reader/writer 2000 according to the fifth embodiment is described below. When data is transferred to the noncontact information medium 2200 from the reader/writer 2000, data from the external device (not shown) is processed by the controller 160 of the reader/writer 2000, and transmitted to the transmission section 161. In the transmission section 161, a high frequency signal having a specific amplitude is supplied as a carrier from the oscillation circuit 162. The carrier is modulated by the modulation circuit 163 so that the modulated high frequency signal is output. The modulated high frequency signal output from the modulation circuit 163 is supplied to the antenna section 2110 through the driver circuit 164. The cancellation section 165 generates a specific pulse signal in synchronization with the OFF timing of the modulated high frequency signal to contribute to a reduction in the damped oscillation in the loop antenna 112.

In the noncontact information medium 2200, the modulated high frequency signal is supplied to the receiver circuit 180 through the antenna section 186. The modulated high frequency signal is also supplied to the power supply circuit 182 so that a specific power supply voltage necessary for each section of the noncontact information medium 2200 is generated. The data output from the receiver circuit 180 is demodulated and supplied to the logic control circuit 184. The logic control circuit 184 operates based on the output from a clock 183. The logic control circuit 184 processes the supplied data and writes specific data into a memory 185.

When data is transferred to the reader/writer 2000 from the noncontact information medium 2200, an unmodulated high frequency signal having a specific amplitude is output from the modulation circuit 163 of the reader/writer 2000. The high frequency signal is transferred to the noncontact information medium 2200 through the driver circuit 164 and the loop antenna 112 of the antenna section 2110.

In the noncontact information medium 2200, the data read from the memory 185 is processed by the logic control circuit 184 and supplied to the transmission circuit 181. In the transmission circuit 181, the switch is turned ON/OFF depending on the "1" or "0" bit of the data.

In the reader/writer 2000, the load of the loop antenna 112 of the antenna section 2110 changes when the switch of the transmission circuit 181 is turned ON/OFF. Therefore, the amplitude of the high frequency current which flows through the loop antenna 112 changes. Specifically, the amplitude of the high frequency current is modulated by the data supplied from the noncontact information medium 2200. The high frequency current is detected by the detection section 169 of the reception section 168 and demodulated by the demodulator circuit 170 to obtain data. The data is processed by the controller 160 and transmitted to the external device or the like.
5.3. The electronic circuit and the electronic instrument according to the fifth embodiment include the surface acoustic wave device having a large electromechanical coupling factor according to the invention. Therefore, according to the fifth embodiment, power consumption of the electronic circuit and the electronic instrument can be reduced.

The embodiments of the invention are described above in detail. A person skilled in the art would readily understand that various modifications may be made without substantially departing from the new matter and the effects of the invention. Therefore, such modifications are entirely included within the scope of the invention.

For example, the frequency filter and the oscillator according to the invention may be respectively applied to a broadband filter and a VCO in a UWB system, portable telephone, wireless LAN, and the like.

In the above-described embodiment, the communication system using the portable telephone and the reader/writer is described as an example of the electronic instrument, and the electronic circuit provided in the portable telephone and the reader/writer is described as an example of the electronic circuit. However, the invention is not limited thereto. The invention may be applied to various mobile telecommunication instruments and electronic circuits provided therein. For example, the invention may be applied to communication instruments used in a stationary state such as a tuner which receives broadcast satellite (BS) broadcasts and electronic circuits provided therein, and electronic instruments such as a HUB using an optical signal propagated through an optical cable and electronic circuits provided therein.

Although only some embodiments of the present invention have been described in detail above, those skilled in the art will readily appreciate that many modifications are possible in the embodiments without materially departing from the novel teachings and advantages of this invention. Accordingly, all such modifications are intended to be included within scope of this invention.

## Claims

1. A lead zirconate titanate niobate film epitaxially grown in a tetragonal (110) or (101) orientation or a rhombohedral (110) orientation.

2. The lead zirconate titanate niobate film as defined in claim 1, having twofold inplane symmetry.

3. The lead zirconate titanate niobate film as defined in claim 1 or 2, including niobium in an amount of 5 to 30 mol% of a total amount of niobium, titanium, and zirconium.

4. The lead zirconate titanate niobate film as defined in any one of claims 1 to 3, comprising silicon or silicon and germanium in an amount of 0.5 mol% or more.

5. A lead zirconate titanate niobate laminate comprising a sapphire substrate and a lead zirconate titanate niobate film formed on the sapphire substrate.

6. The lead zirconate titanate niobate laminate as defined in claim 5, wherein the sapphire substrate is an R-plane (1-102) sapphire substrate.

7. The lead zirconate titanate niobate laminate as defined in claim 5 or 6, wherein the lead zirconate titanate niobate film is epitaxially grown in a tetragonal (110) or (101) orientation or a rhombohedral (110) orientation.

8. The lead zirconate titanate niobate laminate as defined in claim 7, wherein the lead zirconate titanate niobate film has twofold inplane symmetry.

9. The lead zirconate titanate niobate laminate as defined in claim 7, wherein a [001] axis in the tetragonal (110) orientation, a [010] axis in the tetragonal (101) orientation, or a [001] axis in the (110) orientation of the lead zirconate titanate niobate film is parallel to a [11-20] direction of the R-plane of the sapphire substrate.

10. The lead zirconate titanate niobate laminate as defined in any one of claims 5 to 9, wherein the lead zirconate titanate niobate film includes niobium in an amount of 5 to 30 mol% of the total amount of niobium, titanium, and zirconium.

11. The lead zirconate titanate niobate laminate as defined in any one of claims 5 to 10, wherein the lead zirconate titanate niobate film includes silicon or silicon and germanium in an amount of 0.5 mol% or more.

12. A method of manufacturing a lead zirconate titanate niobate laminate, the method comprising:
providing a sapphire substrate;
providing a precursor composition including a precursor for forming a lead zirconate titanate niobate film, the precursor including at least niobium, titanium, and zirconium and having a partial ester bond; and
applying the precursor composition to the sapphire substrate and heating the precursor composition to form a lead zirconate titanate niobate film.

13. The method of manufacturing a lead zirconate titanate niobate laminate as defined in claim 12, wherein the precursor further includes lead.

14. The method of manufacturing a lead zirconate titanate niobate laminate as defined in claim 12 or 13, wherein the precursor is dissolved or dispersed in an organic solvent.

15. The method of manufacturing a lead zirconate titanate niobate laminate as defined in claim 14, wherein the organic solvent is an alcohol.

16. The method of manufacturing a lead zirconate titanate niobate laminate as defined in any one of claims 12 to 15, wherein the precursor composition is obtained by mixing a sol-gel raw material including a hydrolysis-condensation product of a metal alkoxide of at least niobium, titanium, and zirconium, a polycarboxylic acid or a polycarboxylic acid ester, and an organic solvent, and includes the precursor having an ester bond obtained by esterification of the polycarboxylic acid or a polycarboxylic acid derived from the polycarboxylic acid ester and the metal alkoxide.

17. The method of manufacturing a lead zirconate titanate niobate laminate as defined in claim 16, wherein the polycarboxylic acid or the polycarboxylic acid ester is a dicarboxylic acid or a dicarboxylic acid ester.

18. The method of manufacturing a lead zirconate titanate niobate laminate as defined in claim 17, wherein the dicarboxylic acid ester is at least one ester selected from a succinic acid ester, a maleic acid ester, and a malonic acid ester.

19. The method of manufacturing a lead zirconate titanate niobate laminate as defined in any one of claims 16 to 18, wherein the precursor composition is obtained by mixing a sol-gel raw material using a metal carboxylate together with the sol-gel raw material, the polycarboxylic acid or the polycarboxylic acid ester, and the organic solvent.

20. The method of manufacturing a lead zirconate titanate niobate laminate as defined in claim 19, wherein the metal carboxylate is a lead carboxylate.

21. The method of manufacturing a lead zirconate titanate niobate laminate as defined in any one of claims 16 to 20, wherein the precursor composition is obtained by mixing an organometallic compound together with the sol-gel raw material, the polycarboxylic acid or the polycarboxylic acid ester, and the organic solvent.

22. The method of manufacturing a lead zirconate titanate niobate laminate as defined in any one of claims 16 to 21, wherein the precursor composition is obtained by mixing a sol-gel raw material including silicon or silicon and germanium together with the sol-gel raw material, the polycarboxylic acid or the polycarboxylic acid ester, and the organic solvent.

23. The method of manufacturing a lead zirconate titanate niobate laminate as defined in any one of claims 16 to 22, wherein a mixed solution prepared by mixing at least a PbZrO₃ sol-gel solution, a PbTiO₃ sol-gel solution, and a PbNbO₃ sol-gel solution is used as the sol-gel raw material.

24. The method of manufacturing the lead zirconate titanate niobate laminate as defined in claim 22 or 23, wherein the sol-gel raw material is prepared by further mixing a PbSiO₃ sol-gel solution.

25. A surface acoustic wave device having the lead zirconate titanate niobate film as defined in any one of claims 1 to 4.

26. A surface acoustic wave device having the lead zirconate titanate niobate laminate as defined in any one of claims 5 to 11.

27. A frequency filter having the surface acoustic wave device as defined in claim 25 or 26.

28. An oscillator having the surface acoustic wave device as defined in claim 25 or 26.

29. An electronic circuit having at least one of the frequency filter as defined in claim 27 and the oscillator as defined in claim 28.

30. An electronic instrument having the electronic circuit as defined in claim 29.
